Europäisches Patentamt

European Patent Office

Office européen des brevets

(1) Publication number: **0 170 250 B1**

# EUROPEAN PATENT SPECIFICATION

(45) Date of publication of patent specification: 24.10.90

(21) Application number: 85109543.0

(22) Date of filing: 30.07.85

(51) Int. Cl.⁵: **H 01 L 21/225,** H 01 L 21/28, H 01 L 29/52

(54) Bipolar transistor and method for producing the bipolar transistor.

(30) Priority: 31.07.84 JP 160518/84
07.12.84 JP 258520/84

(43) Date of publication of application:
05.02.86 Bulletin 86/06

(45) Publication of the grant of the patent:
24.10.90 Bulletin 90/43

(84) Designated Contracting States:
DE FR GB

(56) References cited:
GB-A-2 081 507

IBM TECHNICAL DISCLOSURE BULLETIN, vol.
22, no. 12, May 1980, pages 5336-5338, New
York, US; A.P. HO et al.: "Self-aligned process
for forming metal-silicide and polysilicon
composite base contact"

IEEE TRANSACTIONS ON ELECTRON DEVICES,
vol. ED-27, no. 8, August 1980, pages 1390-1394,
New York, US; H. NAKASHIBA et al.: "An
advanced PSA technology for high-speed
bipolar LSI"

(73) Proprietor: KABUSHIKI KAISHA TOSHIBA
72, Horikawa-cho Saiwai-ku
Kawasaki-shi Kanagawa-ken 210 (JP)

(72) Inventor: Komatsu, Shigeru c/o Patent Division
Kabushiki Kaisha Toshiba 1-1 Shibaura 1-chome
Minato-ku Tokyo 105 (JP)
Inventor: Ito, Takao c/o Patent Division
Kabushiki Kaisha Toshiba 1-1 Shibaura 1-chome
Minato-ku Tokyo 105 (JP)
Inventor: Katsumata, Yasuhiro c/o Patent
Division
Kabushiki Kaisha Toshiba 1-1 Shibaura 1-chome
Minato-ku Tokyo 105 (JP)
Inventor: Takaoki, Kiyoshi c/o Patent Division
Kabushiki Kaisha Toshiba 1-1 Shibaura 1-chome
Minato-ku Tokyo 105 (JP)

(74) Representative: Eitle, Werner, Dipl.-Ing. et al
Hoffmann, Eitle & Partner Patentanwälte
Arabellastrasse 4
D-8000 München 81 (DE)

Courier Press, Leamington Spa, England.

## Description

The present invention relates to a method for producing a bipolar transistor comprising:

a first step of forming a collector region of a first conductivity type in a surface area of a silicon substrate;

a second step of forming a non-monocrystalline silicon film on said collector region, and patterning said film to form an opening, followed by forming of an insulation layer on end surfaces of said film which define said opening;

a third step of forming a first base region of a second conductivity type in a surface area of said collector region by using said non-monocrystalline silicon film as a diffusion source of impurity, and forming a second base region of the second conductivity type in the surface area of said collector region and in contact with said first base region; and

a fourth step of forming an emitter region of the first conductivity type in a surface area of said second base region using said film as a mask. Such a method is known from GB—A—2 081 507.

The operation characteristics of the bipolar transistor depend largely on the base-collector parasitic capacitance, the base-emitter parasitic capacitance and the base resistance. In order to improve the performance of a bipolar transistor, these capacitances and resistances must be decreased.

The above-mentioned parasitic capacitances can be sufficiently decreased by known techniques. For example, the base-collector parasitic capacitance can be decreased by forming a conductive layer, connecting the base electrode and base region, with polycrystalline silicon doped with an impurity as in GB—A—2 081 507. However, such conventional techniques have not yet reached a level to sufficiently decrease the base resistance.

A technique using a polycrystalline silicon conductive layer as a diffusion source for an impurity, is known to decrease the resistance within the base region. According to this technique, after an opening is formed in the conductive layer, a high-impurity concentration region is formed as a portion of the base region by thermal diffusion of the impurity in the conductive layer. An active portion of the base region and the emitter region are formed by self alignment, using an oxide film formed on the inner wall of the opening and the conductive layer, as a mask. According to this technique, the active portion of the base region is very finely formed under the emitter region, thereby decreasing the base resistance.

The resistivity of the polycrystalline silicon conductive layer is about three to five times that of the monocrystalline silicon layer which has been doped with an impurity in the same amount as that in the conductive layer. Therefore, a conductive layer as thick as possible (conventionally, 0.4 to 0.6 μm) is formed. However, the conductive layer still has a considerably high resistivity, about 50 to 500 Ω/□). In other words, it is assumed that the resistivity of the conductive layer connecting the base electrode and the base region prevents the base resistance from being sufficiently decreased.

H. Nakashiba et al. discloses a technique for decreasing the resistivity of the conductive layer in "An Advanced PSA Technology for High-Speed Bipolar LSI" on pp. 1390 to 1394, IEEE. Vol. ED—27, No. 8, August 1980. According to this technique, a platinum silicide film is formed on a polycrystalline silicon film so that the resistivity in a multi-conductive layer, consisting of the polycrystalline silicon film and the platinum silicide film, can be decreased to about 2 Ω/□.

Similarly, GB—A—2 081 507 suggests forming a metal silicide film on top of the polysilicon layer.

In accordance with this technique, the emitter electrode is formed on a portion of the polycrystalline silicon film on top of an insulation film and in contact with the emitter region. The platinum silicide film is formed after the formation of the emitter electrode. Therefore, the platinum silicide film cannot cover the entire upper surface of the polycrystalline silicon film. The platinum silicide film is not resistant to high-temperature processing of 800 to 900°C. This prevents the platinum silicide film from being used as the diffusion source of an impurity. Furthermore, the emitter region is not formed in the base region by self-alignment, using the insulation film as a mask. As a result, the emitter region cannot occupy a large area of the active portion (i.e., a portion of low impurity concentration) of the base region, resulting in insufficient decrease of the resistivity of the active region.

IBM Technical Disclosure Bulletin Vol. 22, No. 12, May 1982 discloses a method of forming a metal silicide and polysilicon composite base contact which involves provision of additional oxide and nitride layers in the opening before the formation of the insulation layer. These additional oxide and nitride layers have to be removed before an ion-implantation step to dope emitter and collector contacts.

It is an object of the present invention to provide an improved method for producing bipolar transistor having improved logic operation characteristics and analog operation characteristics in a high frequency range and suitable for integration.

According to the invention, the method initially defined is characterised in that:

said second step includes a sub-step of forming a metal silicide film which completely covers the upper surface of said non-monocrystalline silicon film, a sub-step of patterning said metal silicide film together with said non-monocrystalline silicon film to form said opening thus exposing a portion of said non-monocrystalline silicon film by etching a portion of said metal silicide film, and a sub-step of forming said insulation layer on the end surfaces of said metal silicide film as well as said non-monocrystalline silicon film defining said opening by a process including oxidizing the exposed portion of said non-monocrystalline silicon film;

said fourth step includes a sub-step of forming said emitter region by using said metal silicide film, said non-monocrystalline silicon film and said insulation layer as a mask; and

said third step includes a sub-step of ion-implanting impurity of the second conductivity type into said collector region through said insulation layer and a sub-step of annealing the collector region after the ion-implantation, thereby forming said second base region.

Thus the conductive layer connecting the base region (i.e., first and second regions) and the base electrode has a multi-layer structure of a polycrystalline silicon film and a metal silicide film. The metal silicide film is overlaid on the entire upper surface of the polycrystalline silicon film. Its resistivity is sufficiently lower than that of the polycrystalline silicon. Therefore, when the ratio of the metal silicide film in the conductive layer is increased, as described above, the resistance of the conductive layer is decreased. Furthermore, the emitter region is formed in the second base region using the conductive layer and the insulation layer formed on the end surfaces of the conductive layer as a mask. When a thin insulation layer on the order of submicrons is formed, the distance between the emitter region and the conductive layer can be sufficiently decreased. In other words, the ratio of the emitter region in the base region can be increased, thereby decreasing the resistance of the base region. As a result, the base resistance rbb' of the bipolar transistor may be greatly decreased in accordance with the decrease in resistivity of the conductive layer and the base region.

This invention can be more fully understood from the following detailed description when taken in conjunction with the accompanying drawings, in which :

Figs. 1 to 8 are views for explaining a first embodiment of the present invention, and show manufacturing steps of an npn bipolar transistor;

Fig. 9 is a view for explaining a second embodiment of the present invention, and shows a manufacturing step corresponding to the manufacturing step shown in Fig. 3 of the first embodiment; and

Fig. 10 shows relationships between etching time and etching depth for the purpose of comparing etching rates of an $MoSi_2$ film and a polycrystalline silicon film.

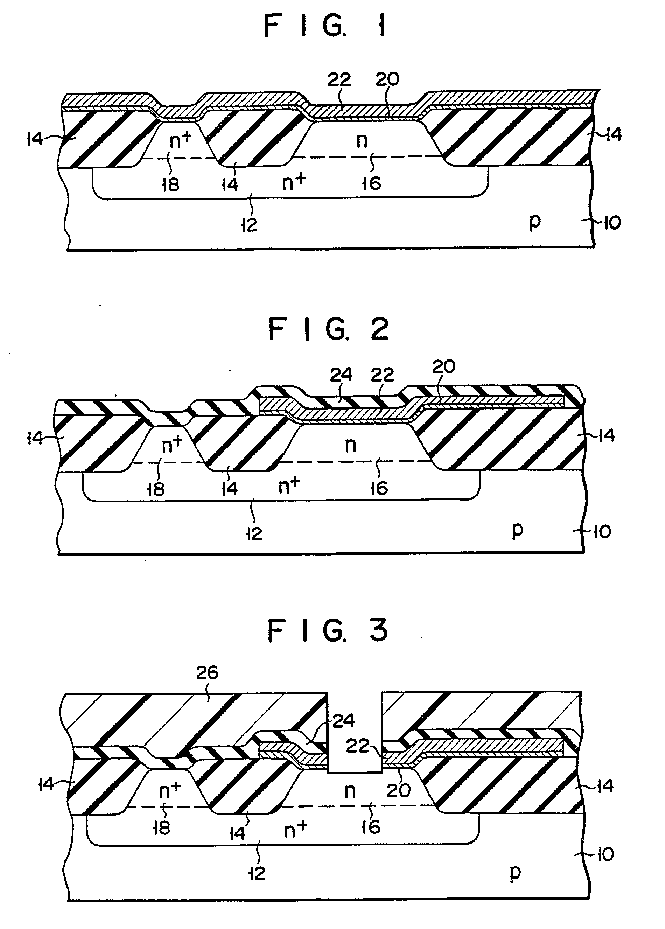

A method for producing a bipolar transistor according to an embodiment of the present invention, will be described with reference to Figs. 1 to 8. Figs. 1 to 8 show manufacturing steps of an npn bipolar transistor. A p-type silicon semiconductor substrate 10 is provided in the first step shown in Fig. 1. An $n^+$-type region 12 is formed in a surface area of the substrate 10. Thereafter, an n-type layer (not shown) is formed through a process of epitaxial growth on the substrate 10 and the $n^+$-type region 12, to cover their entire surfaces. The semiconductor structure prepared in the above step is selectively oxidized in order to form the field insulation layer 14 shown in Fig. 1. The layer 14 has a thickness of 0.6 to 1 µm, and a bottom contacting the region 12 and the substrate 10. The layer 14 divides the n-type layer (not shown) into first and second regions and surrounds them. The first region is an n-type region 16, shown in Fig. 1. The second region is doped with n-type impurities to form an $n^+$-type region 18, also shown in Fig. 1. The regions 16, 12 and 18 are used as a collector region of the bipolar transistor. Thereafter, undoped polycrystalline silicon is deposited by the LPCVD method on the semiconductor structure to form a polycrystalline silicon film 20 having a thickness of about 0.05 µm. In other words, the film 20 is overlaid on the regions 14, 16 and 18 as shown in Fig. 1. Furthermore, $MoSi_2$ is deposited on the film 20 by sputtering to form an $MoSi_2$ film overlay. The film 22 has a thickness of about 0.3 µm.

The films 20 and 22 are patterned as shown in Fig. 2. A patterning method such as chemical dry etching (CDE) or reactive ion etching (RIE) is employed. The region 18 is exposed by this patterning. Then, boron is ion-implanted into the films 22 and 20 at a dose of $10^{15}$ to $10^{16}$ $cm^{-2}$ and an energy of 40 to 50 keV. An $SiO_2$ film 24, shown in Fig. 2, is formed by the CVD method to a thickness of 0.3 to 0.4 µm to cover the layer 14, the region 18, and the films 20 and 22.

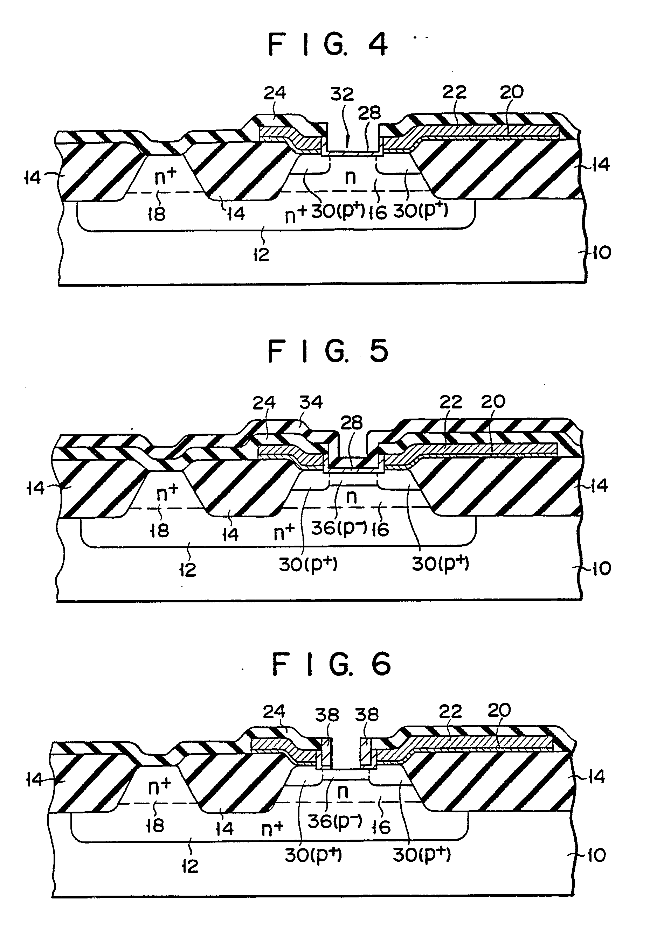

A photoresist pattern 26 is formed on the film 24. As shown in Fig. 3, the region 16 is partially exposed by RIE, using the pattern 26 as a mask. In this etching, an $SF_6$ gas is used for removing a portion of the film 24, and a gas mixture of $BCl_3$ and $Cl_2$ is used for removing portions of the films 22 and 20. This process etches the region 16 for 0.1 to 0.3 µm, as shown in Fig. 3, to remove the film 20 from the entire portion of the region 16 to be exposed. It must be noted that the thicknesses of the films 20 and 22 vary depending on the manufacturing conditions. The portions of the films 22 and 20 left after etching are used as a multi-conductive layer connecting the base electrode and the base region of a bipolar transistor. The photoresist pattern 26 is removed after this RIE. Exposed portions of the films 20 and 22, and the region 16 are damaged by the RIE. In order to remove the damaged portions, alkali wet etching is applied. The semiconductor structure mentioned above is thermally oxidized to form an oxide film 28 having a thickness of 0.05 µm on the region 16 and the inner surface of the opening in the films 20 and 22 as shown in Fig. 4. After the formation of the film 28, a thermal process at a temperature of 1,000 to 1,100°C is applied to the semiconductor structure, thereby diffusing boron from the films 22 and 20 to the region 16. A $p^+$-type region 30, shown in Fig. 4, is formed through this process in the surface area of the region 16 and in contact with the film 20. After the formation of the region 30, boron is ion-implanted at a dose of $10^{14}$ $cm^{-2}$ and an energy of 40 keV in the surface area of the region 16 through an opening 32, as shown in Fig. 4.

After this ion-implantation, an $SiO_2$ film 34, shown in Fig. 5, is formed by the CVD method to a thickness of 0.3 to 0.5 µm. The film 34 covers the entire surfaces of the films 24 and 28. The semiconductor structure is heated to 800 to 900°C so as to anneal the film 34 and the region 16. As shown in Fig. 5, a $p^-$-type region 36 is formed in contact with the region 30 by this annealing. The regions 30 and 36 are used as a base region of the bipolar transistor.

The oxide films 34 and 28 are etched by RIE using $CF_4$ gas. In the RIE, an upper surface of the region 36 is partially exposed, and a portion 38 of the film 34 is left along the inner surface of the opening 32 as shown in Fig. 6. The exposed portion of the region 36 is alkali wet-etched in order to reduce the damage caused by the RIE. Thereafter, a polycrystalline silicon film (not shown) is formed on the entire exposed portions of the region 36 and the films 24 and 38. An N-type impurity, such as one or both of arsenic and phosphorus, is ion-implanted at a dose of $10^{15}$ to $10^{16}$ $cm^{-2}$ in the polycrystalline silicon film (not shown).

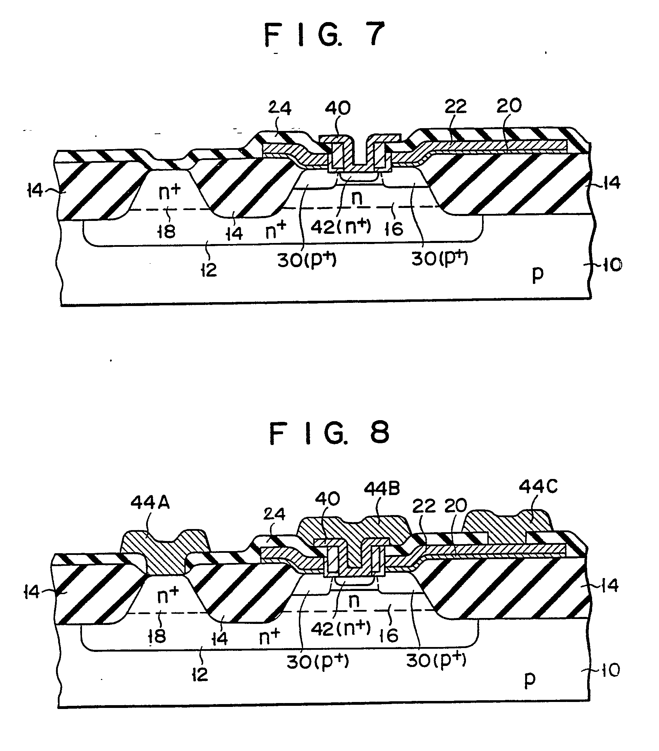

The polycrystalline silicon film (not shown) is patterned, as shown in Fig. 7, to form a polycrystalline silicon film pattern 40. The semiconductor structure is annealed at 800 to 900°C for about 10 minutes so that the n-type impurities are diffused from the pattern 40 to the region 36, thereby forming an $n^+$-type region 42 in the surface area of the region 36, as shown in Fig. 7. The region 42 is used as an emitter region of the bipolar transistor. The pattern 40 is used as an emitter electrode of the bipolar transistor.

The film 24 is selectively etched, as shown in Fig. 8, to expose a portion of film 22 and the region 18. Then, a collector electrode 44A, an emitter electrode 44B and a base electrode 44C are formed in contact with the exposed portions of the region 18, the pattern 40 and the film 22, respectively. The semiconductor structure manufactured by the above-mentioned steps is finally covered with a protective film (not shown), formed by passivation.

In the npn polar transistor shown in Fig. 8, the films 22 and 20 constitute a multi-conductive layer having a resistance sufficiently smaller than that of only a polycrystalline silicon layer. More particularly, the film 22 covers the entire surface of the film 20 so that the multi-conductive layer having a resistance similar to a multi-conductive layer using a platinum silicide film can be obtained. Assuming that the thickness of the film 22 is set to, e.g., 0.3 μm, the resistance of the multi-conductive layer can be decreased to about 1/50 to 1/200 that of only a polycrystalline silicon layer; that is, decreased to 3 to 4 Ω/□.

In the step shown in Fig. 4, p-type impurities are ion-implanted in the films 22 and 20, and the implanted impurities are thermally diffused from the films 20 and 22 to the n-type region 16. Consequently, the $p^+$-type region 30 is formed in the n-type region 16 immediately under the polycrystalline silicon film 20. In the steps shown in Figs. 4 and 5, the $p^-$-type region 36 is formed in the n-type region 16, and in contact with the $p^+$-type region 30, using the films 20, 22 and 24 as a mask. In the step shown in Fig. 7, the $n^+$-type region 42 is formed in the $p^-$-type region 36, using the films 20, 22, 24 and 28 as a mask. In other words, the base region and the emitter region of the bipolar transistor are self aligned to allow micropatterning. In particular, since the thickness of the portion 38 of the $SiO_2$ film 34 is on the order of submicrons, the $p^+$-type region 30 is formed a sufficiently short distance from the $n^+$-type region 42. The effective resistivity of the $p^-$-type region 36 is decreased as the region 42 is increased in depth.

According to the first embodiment described above, the base resistance rbb' of the bipolar transistor can be decreased to about 1/10 that of the conventional resistance, while its high-speed operation performance can be increased by about 20%.

According to the first embodiment described above, the $MoSi_2$ film 22 contacts the $p^+$-type region 30, not directly, but through the polycrystalline silicon film 20, so that good ohmic contact can be obtained. When the film 22 contacts the region 30 directly, the impurity concentration of the $p^+$-type region 30 must be as high as $10^{20}$ $cm^{-3}$. If the impurity concentration of the region 30 cannot be set to this value, the $p^+$-type region 30 and the $MoSi_2$ film 22 will Schottky-contact with each other, thereby increasing the base resistance rbb'. The film 20 prevents the n-type impurities in the region 16 from passing through the film 22 during formation of the $p^+$-type region 30.

According to the first embodiment described above, the $MoSi_2$ film 22 is used as a metal silicide film. However, a $TiSi_2$ film, or a $WSi_2$ film can be used instead. The metal silicide film, such as $MoSi_2$ film, $TiSi_2$ film and $WSi_2$ film, has a resistivity sufficiently lower than that of a polycrystalline silicon film and can be used as a diffusion source of impurities, as in the case of a polycrystalline silicon film. In short, if a metal silicide film is resistant to a thermal process at 900 to 1,000°C, a similar effect to that of the embodiment described above can be obtained.

According to the first embodiment described above, the pattern 40 is used as a diffusion source for an impurity, and the $n^+$-type region 42 is formed by diffusion of the n-type impurity from the pattern 40. However, the region 42 can also be formed by the method of ion implantation. However, when n-type impurities are ion-implanted into the $p^-$-type region 36, processing before formation of the electrodes 44A to 44C, as well as the processing of the protective film, may become difficult. Therefore, this method is not preferable.

According to the first embodiment described above, the p-type impurity is doped by ion implantation in the polycrystalline silicon film and thermally diffused to form the $p^+$-type region 30. However, a polycrystalline silicon can also be deposited together with n-type impurities by the LPCVD method. When only arsenic is used as the n-type impurity, thermal diffusion is performed at, preferably, a high temperature of 900 to 1,000°C. Since arsenic has a smaller diffusion coefficient than phosphorus, a higher temperature is required for diffusing arsenic than that required for diffusing either phosphorus or a mixture of phosphorus and arsenic.

Referring to the first embodiment described above, the polycrystalline silicon film 20, shown in Fig. 1, varies depending upon the manufacturing conditions. In the step shown in Fig. 3, the film 20 must be removed in order to expose the region 16. However, the region 16 is formed of silicon which is the same material as the film 20. Therefore, the etching rates thereof are not substantially different from each other. As a result, it is impossible to confirm completion of etching of the film 20 from a relationship between etching time and etching depth. In the embodiment described above, etching is continued for a time period necessary for etching a polycrystalline silicon film having a thickness 120 to 150% that of a preset value, in consideration of a case wherein the film 20 is formed to a thickness greater than the preset value. As a result, a portion of the region 16 may be etched undesirably. Assuming that the film 20 is formed to a thickness less than a preset value, the etched surface of the region 16 may be considerably deeper than a non-etched surface. In this state, when the regions 30 and 36 are formed by the step shown in Fig. 5, the region 36 may not sufficiently contact the region 30. In this case, the bipolar transistor does not operate correctly.

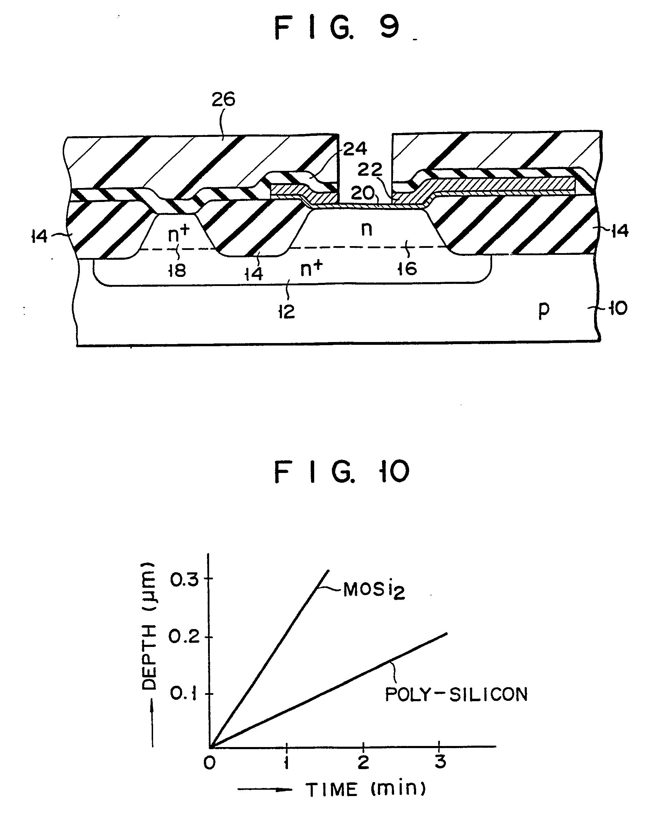

A second embodiment of the present invention will now be described with reference to Fig. 9. In this embodiment, a step of the first embodiment shown in Fig. 3 is modified in order to produce a bipolar transistor, shown in Fig. 8. More particularly, manufacturing steps similar to those of the first embodiment are provided in the second embodiment, excluding the step shown in Fig. 3. After the step shown in Fig. 2, a photoresist pattern 26, as shown in Fig. 9, is formed on the SiO₂ film 24. The films 24 and 22 are patterned by using the pattern 26 as a mask, and an opening is formed above the region 16. The film 24 is removed by RIE using $CF_4$ gas, and the film 22 is removed by RIE using a mixture of $Cl_2$ and $O_2$ gases. Fig. 10 is a graph showing etching rates of the MoSi₂ film and the polycrystalline silicon film. As is apparent from Fig. 10, the etching rate of the polycrystalline silicon film is lower than that of the MoSi₂ film. The etching can be stopped without substantially etching the film 20.

After this etching, the pattern 26 is removed. The exposed portions of the films 22 and 20 are thermally oxidized to form an oxide film 28 as shown in Fig. 4. The subsequent steps for producing the bipolar transistor are the same as those of the first embodiment.

According to the second embodiment, the regions 30 and 36 are formed to contact each other. Since the etching rate of the film 22 is higher than that of the film 20, completion of etching of the MoSi₂ film can be easily confirmed, resulting in an advantage in process control.

According to the second embodiment, the film 28 is formed by thermal oxidation of the polycrystalline silicon film 20, and, thereafter, boron is ion-implanted in the region 16 through the film 28 in order to form the p⁻-type region 36. The film 28 can be removed by etching using, for example, ammonium fluoride. In this case, the exposed portion of the region 16 is oxidized to form another oxide film. Boron is ion-implanted in the region 16 through the second oxide film. The second oxide film has a uniform thickness to allow uniform boron doping in the region 16.

## Claims

1. A method for producing a bipolar transistor comprising:

a first step of forming a collector region (16) of a first conductivity type in a surface area of a silicon substrate (10, 12, 18);

a second step of forming a non-monocrystalline silicon film (20) on said collector region (16), and patterning said film (20) to form an opening, followed by forming of an insulation layer (28) on end surfaces of said film (20) which define said opening;

a third step of forming a first base region (30) of a second conductivity type in a surface area of said collector region (16) by using said non-monocrystalline silicon film (20) as a diffusion source of impurity, and forming a second base region (36) of the second conductivity type in the surface area of said collector region (16) and in contact with said first base region (30); and

a fourth step of forming an emitter region (42) of the first conductivity type in a surface area of said second base region (36) using said film (20) as a mask; characterised in that:

said second step includes a sub-step of forming a metal silicide film (22) which completely covers the upper surface of said non-monocrystalline silicon film (20), a sub-step of patterning said metal silicide film (22) together with said non-monocrystalline silicon film (20) to form said opening thus exposing a portion of said non-monocrystalline silicon film (20) by etching a portion of said metal silicide film (22), and a sub-step of forming said insulation layer (28) on the end surfaces of said metal silicide film (22) as well as said non-monocrystalline silicon film (20) defining said opening by a process including oxidizing the exposed portion of said non-monocrystalline silicon film (20);

said fourth step includes a sub-step of forming said emitter region (42) by using said metal silicide film (22), said non-monocrystalline silicon film (20) and said insulation layer (28, 38) as a mask; and

said third step includes a sub-step of ion-implanting impurity of the second conductivity type into said collector region (16) through said insulation layer (28) and a sub-step of annealing the collector region (16) after the ion-implantation, thereby forming said second base region (36).

2. A method according to claim 1, characterised in that said metal silicide film (22) is formed of molybdenum silicide (MoSi$_2$).

3. A method according to claim 1, characterised in that said metal silicide film (22) is formed of titanium silicide (TiSi$_2$).

4. A method according to claim 1, characterised in that said metal silicide film (22) is formed of tungsten silicide (WSi$_2$).

**Patentansprüche**

1. Verfahren zur Herstellung eines bipolaren Transistors, welches umfaßt:

einen ersten Schritt zum Bilden eines Kollektorgebietes (16) eines ersten Leitfähigkeitstyps in einer Oberflächenzone eines Siliziumsubstrats (10, 12, 18);

einen zweiten Schritt zum Bilden eines nicht-monokristallinen Siliziumfilms (20) auf dem Kollektorgebiet (16), und des Versehens des Films (20) mit einem Muster, um eine Öffnung zu bilden, gefolgt vom Bilden einer Isolierschicht (28) auf Endoberflächen des Films (20), welche die Öffnung definieren;

einen dritten Schritt zum Bilden eines ersten Basisgebietes (30) eines zweiten Leitfähigkeitstyps in einem Oberflächenbereich des Kollektorgebietes (16) durch Verwenden des nicht-monokristallinen Siliziumfilms (20) als eine Störstoff-Diffusionsquelle, und zum Bilden eines zweiten Basisgebietes (36) des zweiten Leitfähigkeitstyps in der Oberflächenzone des Kollektorgebietes (16) und in Kontakt mit dem ersten Basisgebiet (30); und

einen vierten Schritt zum Bilden eines Emittergebietes (42) des ersten Leitfähigkeitstyp in einem Oberflächenbereich des zweiten Basisgebietes (36) unter Verwendung des Films (20) als eine Maske; dadurch gekennzeichnet, daß

der zweite Schritt einen Unterschritt zum Bilden eines Metallsilizidfilms (22), welcher die obere Oberfläche des nicht-monokristallinen Siliziumfilms (20) vollständig bedeckt, einen Unterschritt des Versehens des Metallsilizidfilms (20) zusammen mit dem nicht-monokristallinen Siliziumfilm (20) mit einem Muster, um die Öffnung zu bilden, wobei so durch Ätzen eines Teiles des Metallsilizidfilms (22) ein Teil des nicht-monokristallinen Siliziumfilms (20) freigelegt wird, und einen Unterschritt zum Bilden der Isolierschicht (28) auf den Endoberflächen des Metallsilizidfilms (22) sowie auf dem nicht-monokristallinen Siliziumfilm (20), welcher die Öffnung definiert, durch einen Prozess, welcher Oxidieren des freigelegten Teils des nicht-monokristallinen Siliziumfilms (20) einschließt, einschließt;

der vierte Schritt einen Unterschritt zum Bilden des Emittergebietes (42) durch Verwendung des Metallsilizidfilms (22), des nicht-monokristallinen Siliziumfilms (20) und der Isolierschicht (28, 38) als eine Maske einschließt; und

der dritte Schritt einen Unterschritt des Ionenimplantierens eines Störstoffes des zweiten Leitfähigkeitstyps in das Kollektorgebiet (16) durch die Isolierschicht (28) und einen Unterschritt des Glühens des Kollektorgebietes (16) nach der Ionenimplantation, wodurch das zweite Basisgebiet (36) gebildet wird, einschließt.

2. Verfahren nach Anspruch 1, dadurch gekennzeichnet, daß der Metallsilizidfilm (22) aus Molybdän-Silizid (MoSi$_2$) gebildet ist.

3. Verfahren nach Anspruch 1, dadurch gekennzeichnet, daß der Metallsilizidfilm (22) aus Titan-Silizid (TiSi$_2$) gebildet ist.

4. Verfahren nach Anspruch 1, dadurch gekennzeichnet, daß der Metallsilizidfilm (22) aus Wolfram-Silizid (WSi$_2$) gebildet ist.

**Revendications**

1. Procédé de production d'un transistor bipolaire, comprenant:

une première opération consistant à former une région de collecteur (16) d'un premier type de conductivité dans une aire superficielle d'un substrat de silicium (10, 12, 18);

une deuxième opération consistant à former une pellicule de silicium non monocristallin (20) sur ladite région de collecteur (16), et à configurer ladite pellicule (20) afin de former une ouverture, après quoi on forme une couche d'isolation (28) sur les surfaces terminales de ladite pellicule (20) qui définissent ladite ouverture;

une troisième opération consistant à former une première région de base (30) d'un deuxième type de conductivité dans une aire superficielle de ladite région de collecteur (16) en utilisant ladite pellicule de silicium non monocristallin (20) comme source de diffusion d'impureté, et à former une deuxième région de base (36) du deuxième type de conductivité dans l'aire superficielle de ladite région de collecteur (16), en contact avec ladite première région de base (30); et

une quatrième opération consistant à former une région d'émetteur (42) du premier type de conductivité dans une aire superficielle de ladite deuxième région de base (36) en utilisant ladite pellicule (20) comme masque; caractérisé en ce que:

ladite deuxième opération comporte une sous-opération consistant à former une pellicule de siliciure métallique (22) qui recouvre complètement la surface supérieure de ladite pellicule de silicium non monocristallin (20), une sous-opération consistant à configurer ladite pellicule de siliciure métallique (22) en même temps que ladite pellicule de silicium non monocristallin (20) afin de former ladite ouverture, ce qui expose une partie de ladite pellicule de silicium non monocristallin (20), par gravure d'une partie de ladite pellicule de siliciure métallique (22), et une sous-opération consistant à former ladite couche d'isolation (28) sur les surfaces terminales de ladite pellicule de siliciure métallique (22) ainsi que de ladite pellicule de silicium non monocristallin (20) définissant ladite ouverture par un processes comportant l'oxydation de la partie exposée de ladite pellicule de silicium non monocristallin (20);

ladite quatrième opération comporte une sous-opération consistant à former ladite région d'émetteur (42) en utilisant, comme masque, ladite pellicule de siliciure métallique (22), ladite pellicule de silicium non cristallin (20) et ladite couche d'isolation (28, 38); et

ladite troisième opération comporte une sous-opération consistant à effectuer l'implantation ionique d'une impureté du deuxième type de conductivité dans ladite région de collecteur (16) au travers de ladite couche d'isolation (28) et une sous-opération consistant à recuire la région de collecteur (16) après l'implantation ionique, si bien qu'on forme ladite deuxième région de base (36).

2. Procédé selon la revendication 1, caractérisé en ce que ladite pellicule de siliciure métallique (22) est formée de siliciure de molybdène (MoSi$_2$).

3. Procédé selon la revendication 1, caractérisé en ce que ladite pellicule de siliciure métallique (22) est formée de siliciure de titane (TiSi$_2$).

4. Procédé selon la revendication 1, caractérisé en ce que ladite pellicule de siliciure métallique (22) est formée de siliciure de tungstène (WSi$_2$).

# F I G. 1

# F I G. 2

# F I G. 3

F I G. 4

24  32  28  22  20

14

n+

18  14  n+ 30(p+) 16 30(p+)  n

12  10

14

F I G. 5

24  34  28  22  20

14

n+

18  14  n+  36(p-) 16  n

30(p+)  30(p+)

12  10

14

F I G. 6

24  38  38  22  20

14

n+

18  14  n+  36(p-) 16  n

30(p+)  30(p+)

12  10

14

# F I G. 7

# F I G. 8

3

# F I G. 9

# F I G. 10